Europäisches Patentamt

European Patent Office

Office européen des brevets

(19)

(11) **EP 0 735 604 B1**

(12) **EUROPEAN PATENT SPECIFICATION**

(45) Date of publication and mention
of the grant of the patent:
**26.02.2003 Bulletin 2003/09**

(51) Int Cl.7: **H01P 3/02**

(21) Application number: **96104889.9**

(22) Date of filing: **27.03.1996**

(54) **Planar dielectric line and integrated circuit using the same**

Dielektrische Planarleitung und integrierte Schaltung die dieselbe benutzt

Ligne diélectrique planaire et circuit intégré l'utilisant

(84) Designated Contracting States:
**DE FI FR GB NL SE**

(30) Priority: **28.03.1995 JP 6986795**

(43) Date of publication of application:
**02.10.1996 Bulletin 1996/40**

(73) Proprietor: **MURATA MANUFACTURING CO., LTD.
Nagaokakyo-shi Kyoto-fu 226 (JP)**

(72) Inventors:
 • **Ishikawa, Yohei, c/o Murata Co., Ltd.
  Nagaokakyo-shi, Kyoto-fu (JP)**
 • **Hiratsuka, Toshiro,
  c/o Murata Manufact. Co., Ltd.
  Nagaokakyo-shi, Kyoto-fu (JP)**
 • **Yamashita, Sadao,
  c/o Murata Manufact. Co., Ltd.
  Nagaokakyo-shi, Kyoto-fu (JP)**
 • **Iio, Kenichi, c/o Murata Manufact. Co., Ltd.
  Nagaokakyo-shi, Kyoto-fu (JP)**

(74) Representative: **Schoppe, Fritz, Dipl.-Ing.
Schoppe, Zimmermann & Stöckeler
Patentanwälte
Postfach 71 08 67
81458 München (DE)**

(56) References cited:
 **EP-A- 0 040 067       EP-A- 0 244 105
 US-A- 3 026 490**

 • **INTERNATIONAL JOURNAL OF INFRARED AND
  MILLIMETER WAVES, vol. 15, no. 6, June 1994,
  NEW YORK US, pages 1001-1014, XP000454389
  H.C.C. FERNANDES ET AL.: "Metallization
  thickness in bilateral and unilateral finlines"**
 • **IEEE TRANSACTIONS ON MICROWAVE
  THEORY AND TECHNIQUES, vol. 39 , no. 4, April
  1991, NEW YORK US, pages 666-672,
  XP000179063 J.J. LEE : "Slotline impedance"**

EP 0 735 604 B1

**Description**

BACKGROUND OF THE INVENTION

Field of the Invention

The present invention relates to a planar dielectric line for use in a microwave or millimeter-wave band. The invention also relates to an integrated circuit using the dielectric line.

Description of the Related Art

Microwaves and millimeter-waves, which are electromagnetic waves in a very wide range of from 300 MHz to 300 GHz, are used in various types of radar, long-distance telephone networks, television broadcasting relays, satellite communications, etc. Such waves are also coming into wide use in the field of mobile communications. Meanwhile, research is being actively conducted for the development of MMICs, and progress is being made in the downsizing of equipment utilizing electromagnetic waves in the range of microwaves and millimeter-waves. Accordingly, microwaves and millimeter-waves are increasingly coming into a wider range of uses.

Hitherto, several types of transmission lines have been largely used in the range of microwave and millimeter-waves, such as waveguides, coaxial lines, microstrip lines, coplanar lines, slotted lines, and so on. These transmission lines are constructed by forming predetermined electrodes on a dielectric substrate. Waveguides are for use in applications where conductor losses should be inhibited to a low level. Coaxial lines are widely used as connecting cables between equipment. Coplanar lines, microstrip lines, slotted lines, etc. are largely employed for forming connections between electronic parts, such as ICs, since they are easily connected thereto.

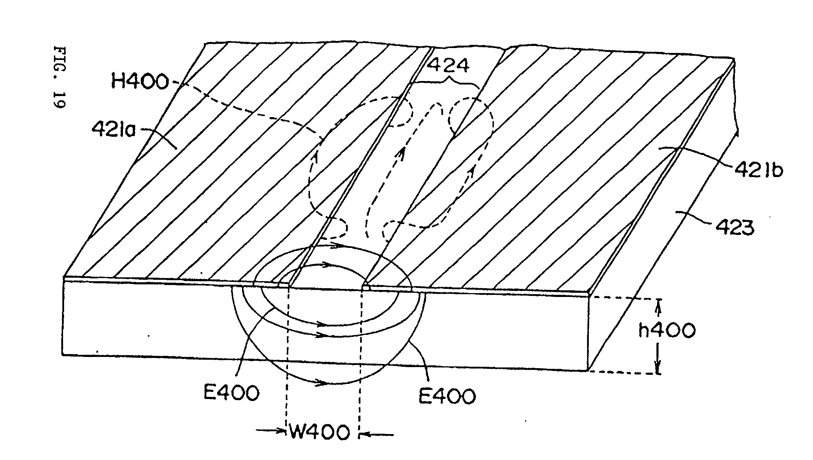

A slotted line is, as shown in Fig. 19, constructed in such a manner that electrodes 421a and 421b are disposed across a predetermined spacing on the top surface of a dielectric substrate 423 having a predetermined thickness h400. This achieves the formation of a slot 424 having a predetermined width W400 sandwiched between the electrodes 421a and 421b. In the slotted line constructed as described above, an electromagnetic wave forms a mode having an electric field E400 in parallel to the width of the slot 424 and a magnetic field H400 in parallel to the longitudinal direction of the slot 424, thereby propagating in the longitudinal direction of the slot 424.

Further, in addition to the above-described transmission lines, nonradiative dielectric waveguides (NRD) are used. An NRD is constructed by interposing a square-prism-shaped dielectric member between conductive plates, and causes only a low level of conductor losses.

The transmission lines mentioned above have various disadvantages in the microwave and millimeter-wave bands. Waveguides, which are of large size, cannot achieve downsizing and weight reduction and are difficult to connect with electronic parts, such as ICs. In coaxial lines, an unnecessary high-order mode is generated at a frequency higher than a specific frequency determined by the cross sectional configuration of the coaxial lines so as to increase conductor losses, thus rendering the lines inoperable. In order to avoid this problem, it is necessary to reduce the diameter of the coaxial line to approximately 1 mm when the line is used at a frequency in a millimeter-wave band as high as 60 GHz, which makes it difficult to manufacture. Microstrip lines, coplanar lines and slotted lines exhibit extremely large conductor losses. Additionally, NRD lines are difficult to connect to electronic parts, such as ICs.

International Journal of Infrared and Millimeter Waves, Vol. 15, No. 6, June 1994, New York, U.S., pages 1001 to 1014, discloses a method for calculating the effective dielectric constant and the characteristic impedance of bilateral and unilateral finelines with a full wave analysis. The bilateral fineline comprises a dielectric substrate having first and second surfaces, which opposedly face each other, a metallization formed on the first and the second surface of the dielectric substrate, and a first slot and a second slot having substantially the same width and being formed in the metallization on the first and the second surface of the dielectric substrate, respectively, wherein the second slot opposedly facing the first slot.

IEEE Transactions on Microwave Theory and Techniques, Vol. 39, No. 4, April 1991, New York, U.S., pages 666 to 672, disclose a method for calculating the slotline impedance and the effective dielectric constant of, for example, a double-sided slotline. The double-sided slotline comprises a substrate having first and second surfaces which opposedly face each other, and a conducting plane printed on the first and second surface of the substrate. Slots are etched into each conducting plane on the first and second surfaces of the substrate and are opposedly facing each other to form the double-sided slotline.

SUMMARY OF THE INVENTION

Accordingly, in order to overcome the above-described drawbacks, it is an object of the present invention to provide a small and inexpensive planar dielectric line in which easier connection with electronic parts, such as ICs and the like, can be achieved and conductor losses can be inhibited to a much lower level than those of conventional microstrip lines, coplanar lines, slotted lines and so on.

It is another object of the present invention to provide an integrated circuit with comparatively improved compactness and strength.

These objects are achieved by a planar dielectric transmission line according to claim 1 and an integrated circuit according to claim 4.

In order to achieve the above objects, according to a first aspect of the present invention, there is provided a planar dielectric line comprising: a dielectric substrate having first and second surfaces which opposedly face each other; a first slot having a predetermined width and being interposed between first and second electrodes, the first and second electrodes being formed on the first surface of the dielectric substrate and opposedly facing each other across a predetermined spacing; and a second slot having substantially the same width as the first slot and being interposed between third and fourth electrodes, opposedly facing the first slot, the third and fourth electrodes being formed on the second surface of the dielectric substrate and opposedly facing each other across a predetermined spacing, wherein the dielectric constant and the thickness of the dielectric substrate are determined so that a plane electromagnetic wave having a predetermined frequency and propagating in a propagation region of the dielectric substrate interposed between the first and second slots is totally reflected by the first and second surfaces of the dielectric substrate adjacent to the first and second slots, respectively.

According to a second aspect of the present invention, there is provided a planar dielectric line, further comprising a first conductive plate disposed away from the first surface of the dielectric substrate across a predetermined distance, and a second conductive plate disposed away from the second surface of the dielectric substrate across a predetermined distance.

According to a third aspect of the present invention, there is provided a planar dielectric line, wherein a dielectric is disposed between the first surface of the dielectric substrate and the first conductive plate and between the second surface of the dielectric substrate and the second conductive plate, the dielectric having a lower dielectric constant than that of the dielectric substrate.

According to a fourth aspect of the present invention, there is provided an integrated circuit comprising a transmission line and a high-frequency device connected to the transmission line, wherein the transmission line includes at least one of the planar dielectric lines of the types described above.

In the planar dielectric line according to the first aspect of the present invention, in the propagation region of the dielectric substrate, an electromagnetic wave having a frequency higher than a predetermined frequency is totally reflected by the first surface of the substrate adjacent to the first slot and by the second surface of the substrate near the second slot. On the other hand, the portions of the substrate other than the propagation region, interposed between the first and second electrodes, attenuate the plane electromagnetic wave. Accordingly, a high-frequency signal having a frequency higher than a predetermined frequency is propagated in the dielectric line while concentrating inside and in the vicinity of the propagation region.

The planar dielectric line according to the second aspect of the present invention is constructed by adding the additional first and second conductive plates to the dielectric line implemented by the first aspect of the present invention. This forms a cut-off region between the first electrode and the first conductive plate and also a cut-off region between the second electrode and the first conductive plate, the plane electromagnetic wave being attenuated in both the cut-off regions. A further cut-off region is formed between the third electrode and the second conductive plate so as to attenuate the plane electromagnetic wave. Another cut-off region is also formed between the fourth electrode and the second conductive plate so as to attenuate the plane electromagnetic wave. This further prevents leakage to the exterior of high-frequency signals propagating in the above-described planar dielectric line and also precludes the unnecessary entry of high-frequency signals from the exterior of the dielectric line.

In the planar dielectric line according to the third aspect of the present invention, the following features are added to the dielectric line according to the second aspect of the present invention. Namely, a dielectric is interposed between the first surface of the dielectric substrate and the first conductive plate, and another dielectric is also interposed between the second surface of the substrate and the second conductive plate, each dielectric having a lower dielectric constant than that of the dielectric substrate. This makes it possible to decrease a spacing between the first surface of the substrate and the first conductive plate and also a spacing between the second surface of the substrate and the second conductive plate, thus making the overall planar dielectric line thinner.

The integrated circuit according to the fourth aspect of the present invention comprises a transmission line and a high-frequency device connected to the transmission line. The transmission line includes at least one of the dielectric lines of the types described above.

BRIEF DESCRIPTION OF THE DRAWINGS

Fig. 1 is a perspective view of a planar dielectric line LN10 according to a first embodiment of the present invention;

Fig. 2 is a longitudinal sectional view along line A-A' of Fig. 1;

Fig. 3 is a perspective view of a dielectric-loaded waveguide line LN30 used for explaining the operation of the dielectric lines LN10 and LN20 of the first embodiment and the second embodiments, respectively;

Fig. 4A is a cross sectional view along line C-C' of Fig. 3 illustrating the electromagnetic-field distribution at a frequency not lower than the critical frequency fa at which the incidence angle $\Theta$ is equal to the critical angle $\Theta c$;

Fig. 4B is a longitudinal sectional view along line B-B' of Fig. 3 illustrating the electromagnetic-field distribution at a frequency not lower than the critical frequency fa;

Fig. 5 is a diagram indicating the relationship of the frequency to the phase constant $\beta30$ when the dielectric constant $\varepsilon_r33$ of a dielectric substrate 33 of the waveguide line LN30 shown in Fig. 3 is set to various respective values;

Fig. 6 is a diagram representing the relationship of the frequency to the phase constant $\beta30$ when the thickness t33 of the dielectric substrate 33 shown in Fig. 3 is set to various respective values;

Fig. 7 is a diagram designating the relationship of the critical frequency fa to the dielectric constant $\varepsilon_r33$ of the dielectric substrate 33 of the dielectric-loaded waveguide line LN30;

Fig. 8 is a diagram indicating the relationship of the critical frequency fa to the thickness t33 of the dielectric substrate 33 of the dielectric-loaded waveguide line LN30;

Fig. 9 is a diagram showing the relationship of the frequency to the phase constant $\beta20$ when the dielectric constant $\varepsilon_r23$ of the dielectric substrate 23 of the dielectric line LN20 of the second embodiment is set to several respective values;

Fig. 10 is a diagram indicating the relationship of the frequency to the phase constant $\beta20$ when the width W of the slots 24 and 25 of the dielectric line LN20 was set to several respective values;

Fig. 11A is a cross sectional view along line C-C' of Fig. 3 illustrating the electromagnetic-field distribution at a frequency higher than the critical frequency fa;

Fig. 11B is a longitudinal sectional view along line B-B' of Fig. 3 illustrating the electromagnetic-field distribution at a frequency lower than the critical frequency fa;

Fig. 12 is a cross sectional view of the dielectric line LN20 according to the second embodiment of the present invention;

Fig. 13 is a perspective view of a dielectric substrate 23 illustrating the electromagnetic-field distribution at a frequency lower than the critical frequency fa of the dielectric line LN20 of the second embodiment;

Fig. 14 is a perspective view of the dielectric substrate 23 illustrating the electromagnetic-field distribution at a frequency higher than the critical frequency fa of the dielectric line LN20 of the second embodiment;

Fig. 15 is a cross sectional view of two planar dielectric lines of the second embodiment illustrating the electric-field distribution at a frequency not lower than the critical frequency fa when the planar dielectric lines are disposed in proximity to each other;

Fig. 16 is a cross sectional view of two planar dielectric lines of the second embodiment illustrating the electric-field distribution at a frequency lower than the critical frequency fa when the dielectric lines are disposed in proximity to each other;

Fig. 17    is a perspective view of an example of an application of the dielectric lines according to the present invention;

Fig. 18    is a sectional view along line E-E' of Fig. 17; and

Fig. 19    is a perspective view of a conventional slotted line.

DESCRIPTION OF THE PREFERRED EMBODIMENTS

First Embodiment

A detailed explanation will now be given of a planar dielectric line LN10 according to a first embodiment of the present invention with reference to the drawings.

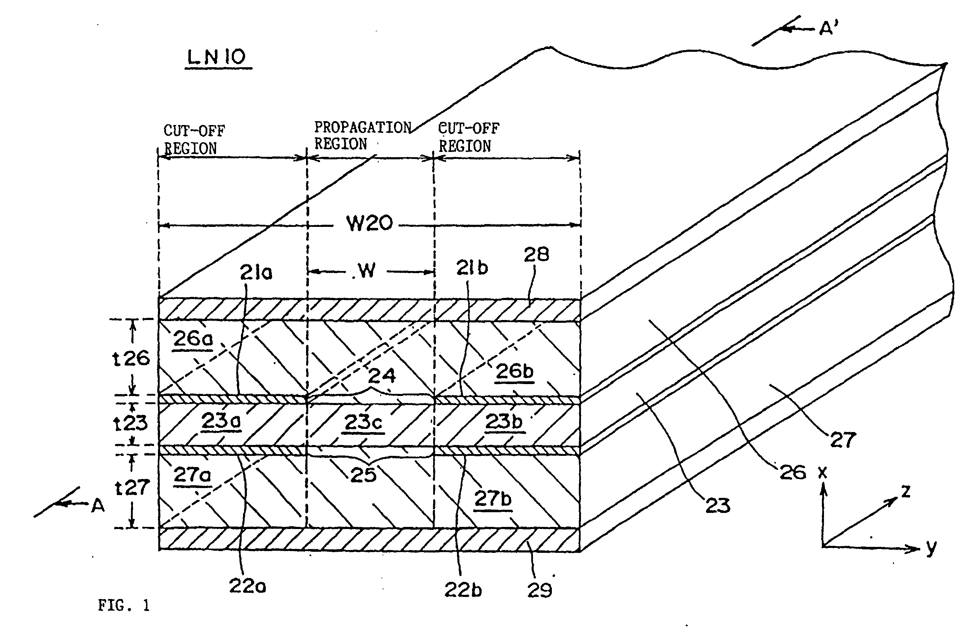

In Fig. 1 a dielectric substrate 23 has a predetermined thickness t23 and a predetermined width W20. On the top surface of the dielectric substrate 23, electrodes 21a and 21b are provided opposedly facing each other across a predetermined spacing. With this arrangement, a slot 24 having width W is formed between the electrodes 21a and 21b.

The slot is located in the central portion of the dielectric substrate 23 along its width and in parallel to the longitudinal direction of the substrate 23. Also, on the bottom surface of the dielectric substrate 23, electrodes 22a and 22b are provided opposedly facing each other across a predetermined spacing. With this arrangement, a slot 25 having the same width W as the slot 24 is formed between the electrodes 22a and 22b so that the slot 25 is located in the central portion of the dielectric substrate 23 along its width and in parallel to the longitudinal direction of the substrate 23. The slots 24 and 25 are formed opposedly facing each other. The dielectric substrate 23 interposed between the slots 24 and 25 serves as a propagation region 23c in which a high-frequency signal having a desired propagation frequency fb is transmitted, as will be described below in a greater detail.

On the top surface of the dielectric substrate 23 having the electrodes 21a and 21b mounted thereon, another dielectric substrate 26 with the same width W20 and length as the substrate 23 is provided. An electrode 28 is further mounted on the entire top surface of the dielectric substrate 26. Also, on the bottom surface of the dielectric substrate 23 having the electrodes 22a and 22b mounted thereon, a dielectric substrate 27 having the same width W20 and length as the dielectric substrate 23 is located. An electrode 29 is disposed on the entire bottom surface of the dielectric substrate 27.

The dielectric constant $\varepsilon_r 26$ of the dielectric substrate 26 is set to be equal to the dielectric constant $\varepsilon_r 27$ of the dielectric substrate 27. On the other hand, the dielectric constant $\varepsilon_r 23$ of the dielectric substrate 23 is set larger than the dielectric constant $\varepsilon_r 26$ and $\varepsilon_r 27$, as will be explained below.

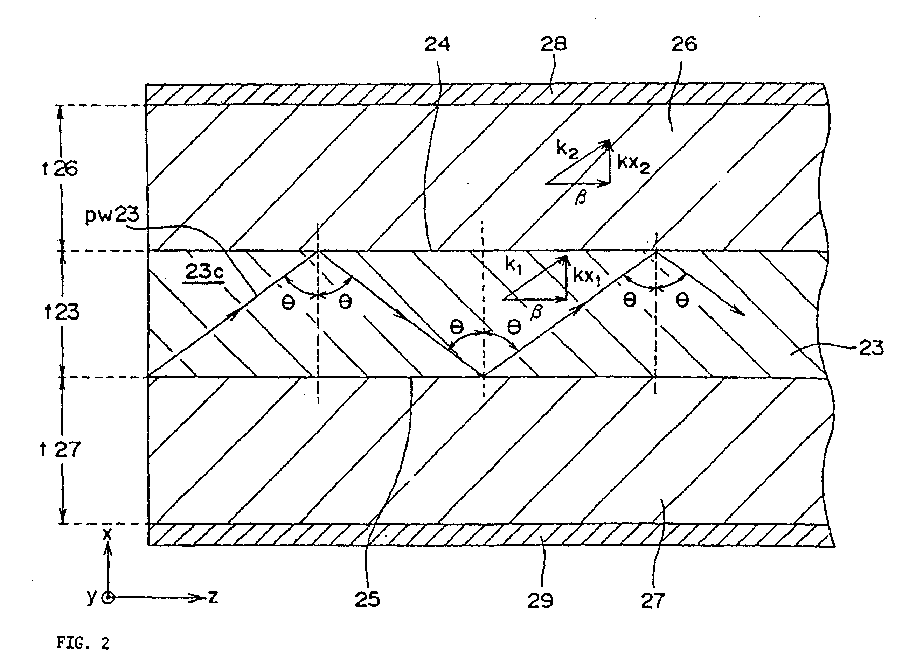

Fig. 2 shows a plane electromagnetic wave pw23 that is incident onto the top surface of the dielectric substrate 23 in the slot 24 at an incidence angle Θ and is reflected at an reflection angle Θ equal to the incidence angle. The top surface of the dielectric substrate 23 in the slot 24 forms a boundary between the dielectric substrates 23 and 26. The plane electromagnetic wave pw23, reflected on the top surface of the dielectric substrate 23 in the slot 24, is incident onto the bottom surface of the dielectric substrate 23 in the slot 25 at an incident angle Θ and is reflected at an reflection angle Θ equal to the incidence angle. The bottom surface of the dielectric substrate 23 in the slot 25 constitutes a boundary between the dielectric substrates 23 and 27. Thereafter, the electromagnetic wave pw23 propagates as a transverse electric (TE) mode within the propagation region 23c of the dielectric substrate 23 while being repeatedly reflected alternately on the top surface of the dielectric substrate 23 in the slot 24 and on the bottom surface of the substrate 23 in the slot 25. An electromagnetic wave propagating in the TE mode will hereinafter be referred to as a "TE wave".

The angle Θ can be expressed by the following equation 1 using the propagation constant $k_1$ of the plane electromagnetic wave pw23 and the phase constant β of the TE wave propagating in the longitudinal direction of the dielectric substrate 23.

$$\Theta = \sin^{-1} (\beta/k_1) \qquad \text{Equation 1}$$

If the incidence angle Θ is larger than the critical angle Θdc expressed by the following equation 2, the electromagnetic wave pw23 is totally reflected on the top surface of the dielectric substrate 23 in the slot 24 and the bottom surface of the substrate 23 in the slot 25, thus propagating within the propagation region 23c of the substrate 23 without

being attenuated.

$$\Theta dc = \sin^{-1}\{\sqrt{(\varepsilon_r 26/\varepsilon_r 23)}\}$$

$$= \sin^{-1}\{\sqrt{(\varepsilon_r 27/\varepsilon_r 23)}\} \qquad \text{Equation 2}$$

On the other hand, if the incidence angle $\Theta$ is smaller than the critical angle $\Theta dc$, the electromagnetic wave pw23 partially permeates into the dielectric substrate 26 or the substrate 27, whereby the wave pw23 is attenuated.

The propagation constant k is determined by the frequency of the plane electromagnetic wave pw23 and the dielectric constant $\varepsilon_r 23$ of the dielectric substrate 23. The phase constant $\beta$ is defined by the frequency of the electromagnetic wave pw23, and the dielectric constant $\varepsilon_r 23$ and the thickness t of the dielectric substrate 23. It will now be assumed that x, y and z axes are determined, as illustrated in Fig. 2, and that a TE wave travels along the z axis while having the constant y component of an electric field Ey. The propagation constant $k_1$ of the planar wave propagating through the dielectric substrate 23 can be expressed by the following equation 3 utilizing the dielectric constant $\varepsilon_r 23$ of the dielectric substrate 23.

$$k_1 = k_0\sqrt{(\varepsilon_r 23)} \qquad \text{Equation 3}$$

Similarly, the propagation constant $k_2$ of the planar wave propagating through the dielectric substrate 26 can be expressed by the following equation 4 utilizing the dielectric constant $\varepsilon_r 26$ of the dielectric substrate 26:

$$k_2 = k_0\sqrt{(\varepsilon_r 26)} \qquad \text{Equation 4}$$

wherein $k_0$ represents the propagation constant of the planar wave in a vacuum. Since the phase constant $\beta$ of the planar wave propagating in the dielectric substrate 23 is equal to that in the dielectric substrate 26, the following equation 5 can hold true:

$$\beta^2 = k_1^2 - kx_1^2 = k_2^2 - kx_2^2 \qquad \text{Equation 5}$$

wherein $kx_1$ and $kx_2$ respectively indicate x components of the propagation constants $k_1$ and $k_2$ of the planar waves propagating through the dielectric substrates 23 and 26. The relation between the propagation constants $kx_1$ and $kx_2$ can be expressed by the following equation 6:

$$(1/kx_1)\tan\{(kx_1\underline{o}(t23/2)\}-(1/kx_2)\tan(kx_2\underline{o}t26) = 0 \qquad \text{Equation 6}$$

Equations 5 and 6 are solved to obtain the propagation constants $kx_1$ and $kx_2$ and the phase constant $\beta$.

The lower the frequency of the plane electromagnetic wave pw23 is, the smaller the incidence angle $\Theta$ is. Hence, as long as the frequency of the electromagnetic wave pw23 is not lower than the critical frequency fda at which the incidence angle $\Theta$ is equivalent to the critical angle $\Theta dc$, the wave will propagate through the dielectric substrate 23 repeating the total reflection on the surface of the dielectric substrate 23 in the slot 24 and on the bottom surface of the substrate 23 in the slot 25. The dielectric constant $\varepsilon_r 23$ and the thickness t23 of the dielectric substrate 23 and the dielectric constant $\varepsilon_r 26$ and $\varepsilon_r 27$ of the substrates 26 and 27, respectively, are set so that a propagation frequency fb is not lower than the critical frequency fda. In other words, the dielectric constant $\varepsilon_r 23$ and the thickness t23 of the dielectric substrate 23 and the dielectric constant $\varepsilon_r 26$ and $\varepsilon_r 27$ of the substrates 26 and 27, respectively, are set so that a planar wave having a propagation frequency fb is totally reflected on the top surface of the dielectric substrate 23 in the slot 24 and on the bottom surface of the substrate 23 close to the slot 25.

The electrodes 21a and 22a, formed opposedly facing each other on the dielectric substrate 23, constitute a planar-parallel waveguide having a cut-off frequency substantially higher than the propagation frequency fb with respect to the TE wave. This forms a TE-wave cut-off region 23a in the dielectric substrate 23. Likewise, the electrodes 21b and 22b, disposed opposedly facing each other, serve as a planar-parallel waveguide having a cut-off frequency substantially higher than the propagation frequency fb with respect to the TE wave. This forms a TE-wave cut-off region 23b along the width of the dielectric substrate 23 in a position opposite to the cut-off region 23a.

Further, the electrode 21a and the portion of the electrode 28 facing each other constitute a planar-parallel waveguide. The thickness t26 of the substrate 26 is set so that the cut-off frequency with respect to the TE wave passing through the plane-parallel waveguide is substantially higher than the propagation frequency fb. Accordingly, a TE-wave cut-off region 26a is formed in the dielectric substrate 26. Similarly, the electrode 21b and the portion of the electrode 28 facing each other constitute a planar-parallel waveguide. A TE-wave cut-off region 26b is thus formed in the dielectric substrate 26 in a position opposite to the cut-off region 26a. Moreover, in the dielectric substrate 27, a planar-parallel waveguide is defined by the electrode 22a and the portion of the electrode 29 opposedly facing each other. The thickness t27 of the dielectric substrate 27 is set so that the TE-wave cut-off frequency of the plane-parallel waveguide is substantially higher than the propagation frequency fb. This forms a TE-wave cut-off region 27a in the dielectric substrate 27. Likewise, a TE-wave cut-off region 27b is formed in the dielectric substrate 27, interposed between the electrode 22b and the electrode 29 opposedly facing each other, in a position opposite to the cut-off region 27a.

In the planar dielectric line LN10 of the first embodiment, a propagation region 23c is defined in which a high-frequency signal having a frequency not lower than the critical frequency fda repeats total reflection alternately on the top surface of the dielectric substrate 23 in the slot 24 and on the bottom surface of the substrate 23 in the slot 25. The cut-off regions 23a, 23b, 26a, 26b, 27a and 27b are, on the other hand, formed to attenuate the high-frequency signal. With this configuration of the line LN10, a TE wave having a frequency not lower than the critical frequency fda propagates through the dielectric substrate 23 of the dielectric line LN10 in the longitudinal direction while concentrating its electromagnetic-field energy inside and in the vicinity of the propagation region 23c.

Also, since the planar dielectric line LN10 comprises the dielectric substrates 23, 26 and 27, it is possible for shorter wavelengths of electromagnetic waves to propagate in the dielectric substrates 23, 26 and 27 than in free space. This further makes it possible to decrease the width and the thickness of the dielectric line LN10 which can thus be made smaller and lighter than square waveguide.

The planar dielectric line LN10 further comprises the electrodes 21a and 21b mounted on the top surface of the dielectric substrate 23 and electrodes 22a and 22b on the bottom surface thereof. The widths W of the slots 24 and 25 are set narrower so that other types of electronic parts, such as ICs or the like, can be directly connected to the electrodes 21a and 21b or the electrodes 22a and 22b, as implemented in the slotted line of the prior art, thereby enabling easy connection between the planar dielectric line LN10 and the other electronic parts, such as ICs.

Second Embodiment

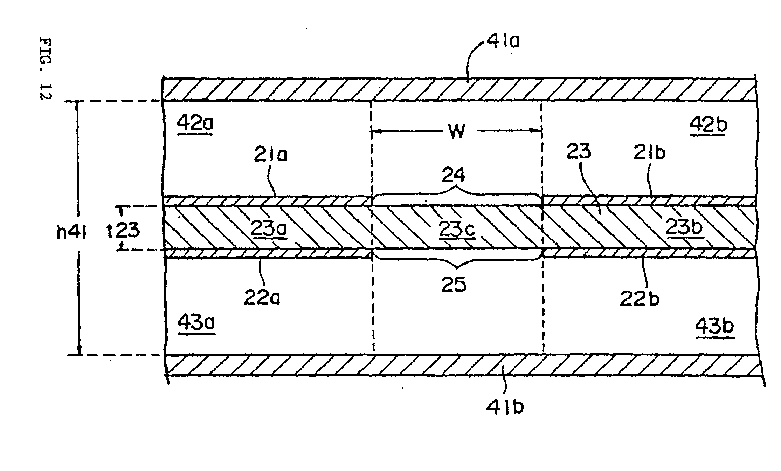

Fig. 12 is a cross sectional view of a planar dielectric line LN20 according to a second embodiment of the present invention. The dielectric line LN20 differs from the dielectric line LN10 in that upper and lower conductive plates 41a and 41b are employed in place of the dielectric substrate 26 and 27 having electrodes 28 and 29.

On the top surface of the substrate 23, the electrodes 21a and 21b are provided opposedly facing each other forming a slot 24. Also, on the bottom surface of the dielectric substrate 23, electrodes 22a and 22b are provided opposedly facing each other forming a slot 25. The upper and lower conductive plates 41a and 41b are provided in parallel to each other across a spacing h41. The dielectric substrate 23 provided with the slots 24 and 25 is disposed in parallel to the upper and lower conductive plates 41a and 41b. The distance between the upper conductive plate 41a and the top surface of the substrate 23 is set to be equal to the distance between the lower conductive plate 41b and the bottom surface of the substrate 23.

In the dielectric line LN20, the dielectric constant $\varepsilon_r23$ of the dielectric substrate 23 is determined as follows. The reflection of an electromagnetic wave on the top surface of the substrate 23 in the slot 24 and on the bottom surface of the substrate 23 in the slot 25 occurs, unlike the first embodiment, at a boundary between the dielectric substrate 23 and free space. The critical angle Θc can, therefore, be expressed by the following equation 7 utilizing the dielectric constant $\varepsilon_r = 1$ of free space:

$$\Theta c = \sin^{-1}\{\sqrt{(1/\varepsilon_r23)}\} \qquad \text{Equation 7}$$

Accordingly, in the planar dielectric line LN20 of this embodiment, the electromagnetic wave pw23 having a frequency not lower than the critical frequency fa at which the angle of reflection Θ becomes equal to the critical angle Θc propagates while repeating the total reflection on the top surface of the dielectric substrate 23 in the slot 24 and on the bottom surface of the substrate 23 in the slot 25. The dielectric constant $\varepsilon_r23$ and the thickness t23 of the substrate 23 are set so that the propagation frequency fb is not lower than the critical frequency fa.

A plane-parallel waveguide is defined by the electrode 21a and the upper conductive plate 41a opposedly facing each other. The spacing h41 between the upper and lower conductive plates 41a and 41b is set so that the TE-wave cut-off frequency of the above-mentioned plane-parallel waveguide is substantially higher than the propagation frequency fb. A TE-wave cut-off region 42a located between the electrode 21a and the upper conductive plate 41a facing each other is thus formed in part of the free space interposed between the dielectric substrate 23 and the upper conductive plate 41a. Likewise, a plane-parallel waveguide is specified by the electrode 21b and the upper conductive plate 41a facing each other. A TE-wave cut-off region 42b between the electrode 21b and the upper conductive plate 41a is thus formed in free space sandwiched between the substrate 23 and the upper conductive plate 41a, in a position opposite to the cut-off region 42a.

As described above, the distance between the upper conductive plate 41a and the top surface of the dielectric substrate 23 is determined equal to the distance between the lower conductive plate 41b and the bottom surface of the substrate 23. Accordingly, a plane-parallel waveguide having a TE-wave cut-off frequency substantially higher than the propagation frequency fb is defined by the electrode 22a and the lower conductive plate 41b opposedly facing each other. A TE-wave cut-off region 43a clamped between the electrode 22a and the lower conductive plate 41b is thus formed in part of the free space interposed between the substrate 23 and the lower conductive plate 41b. Similarly, a TE-wave cut-off region 43b sandwiched between the electrode 22b and the lower conductive plate 41b facing each other is thus defined in the free space in a position opposite to the cut-off region 43a.

In the planar dielectric line LN20, a propagation region 23c is constructed in which a high-frequency signal having a frequency not lower than the critical frequency fa is transmitted in the dielectric substrate 23 while repeating the total reflection alternately on the top surface of the substrate 23 in the slot 24 and on the bottom surface of the substrate 23 in the slot 25. On the other hand, in the cut-off regions 23a, 23b, 42a, 42b, 43a and 43b the high-frequency signal is attenuated. With this construction, a signal having a frequency not lower than the critical frequency fa propagates in the planar dielectric line LN20 while concentrating its electromagnetic energy inside and in the vicinity of the propagation region 23c.

In the second embodiment, the upper and lower conductive plates 41a and 41b are employed in place of the dielectric substrates 26 and 27 used in the first embodiment. This enhances easier construction of the dielectric line LN20 than the dielectric line LN10 of the first embodiment, which leads to a decrease in costs.

A detailed explanation will now be given of the principle of the operation of the dielectric line LN20 according to the second embodiment. Prior to an explanation of this line LN20, a dielectric-loaded waveguide line LN30 operated similar to the line LN20 will first be described.

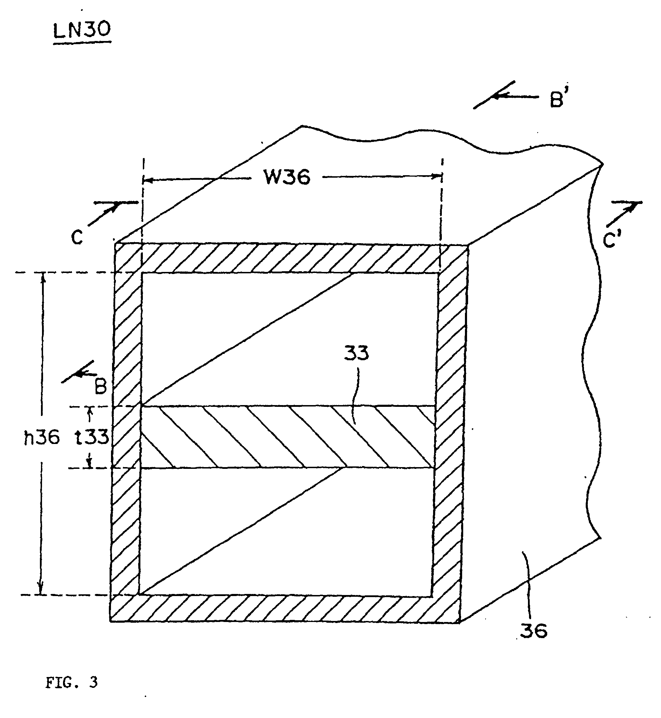

The dielectric-loaded waveguide line LN30, as illustrated in Fig. 3, comprises a square waveguide 36 having an internal width W36 and an internal height h36, and a dielectric substrate 33 having a thickness t33 and a width equal to the width W36 of the waveguide 36. The dielectric substrate 33 is disposed at a central location with respect to the height of the square waveguide 36 so that it can be located in parallel to the upper and lower conductive plates of the waveguide 36. The dielectric constant $\varepsilon_r$33 of the dielectric substrate 33 shall be set to equal the dielectric constant $\varepsilon_r$23 of the dielectric substrate 23 of the second embodiment.

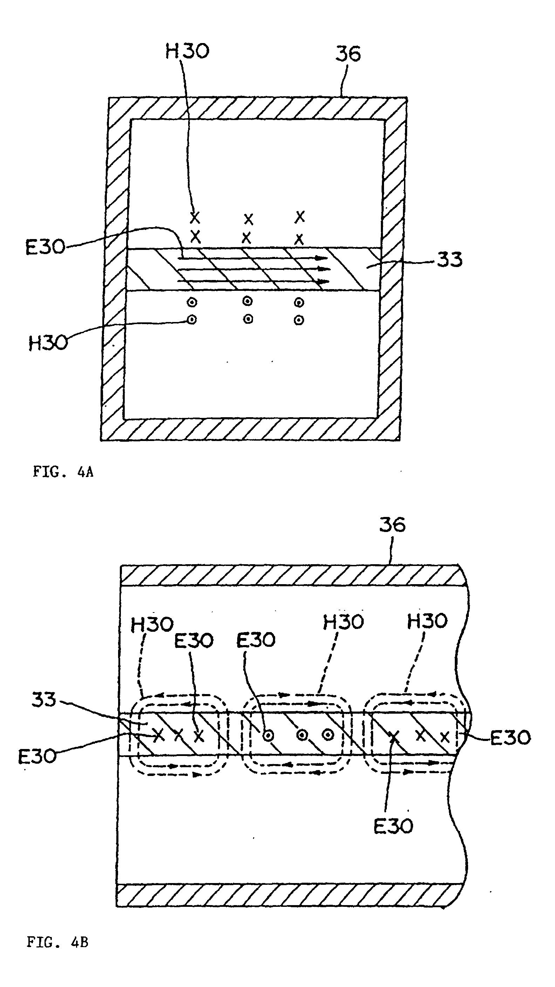

A high-frequency signal having a frequency not lower than the critical frequency fa is input into the waveguide line LN30 shown in Fig. 3 and is propagated in the substrate 33 in the longitudinal direction while concentrating its electromagnetic energy inside and in the proximity of the substrate 33. The electromagnetic-field distribution obtained during the propagation of the signal in the waveguide 36 is indicated in Figs. 4A and 4B. Fig. 4A illustrates an electric field E30 and a magnetic field H30 in a cross sectional view along line C-C' of Fig. 3. Fig. 4B illustrates the electric field E30 and the magnetic field H30 in a longitudinal sectional view along line B-B' of Fig. 3. Figs. 4A and 4B clearly show that the electric field E30 and the magnetic field H30 are distributed inside and in the vicinity of the dielectric substrate 33. The electric field E30 has only a component in the widthwise direction of the substrate 33, while the magnetic field H30 has both a component in the longitudinal direction of the substrate 33, i.e., the longitudinal direction of the waveguide 36, and a component perpendicular to the top surface or the bottom surface of the substrate 33.

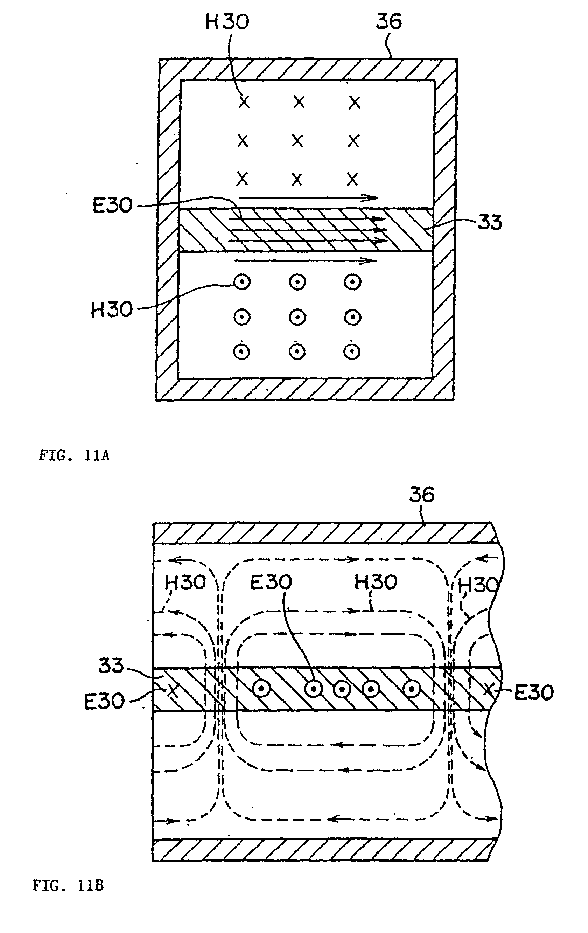

In contrast, Figs. 11A and 11B illustrate an electromagnetic-field distribution obtained when a high-frequency signal having a frequency lower than the critical frequency fa is input into the dielectric-loaded waveguide line LN30. Fig. 11A illustrates the electric field E30 and the magnetic field H30 in a cross sectional view along line C-C' of Fig. 3. Fig. 11B illustrates the electric field E30 and the magnetic field H30 in a longitudinal sectional view along line B-B' of Fig. 3. As is seen from Fig. 11A and 11B, the magnetic field H30 is distributed farther away from the substrate 33 than the magnetic field of the frequency not lower than the critical frequency fa shown in Figs. 4A and 4B, and further, as seen in Fig. 11A, the electric field E30 has a component outside the substrate 33.

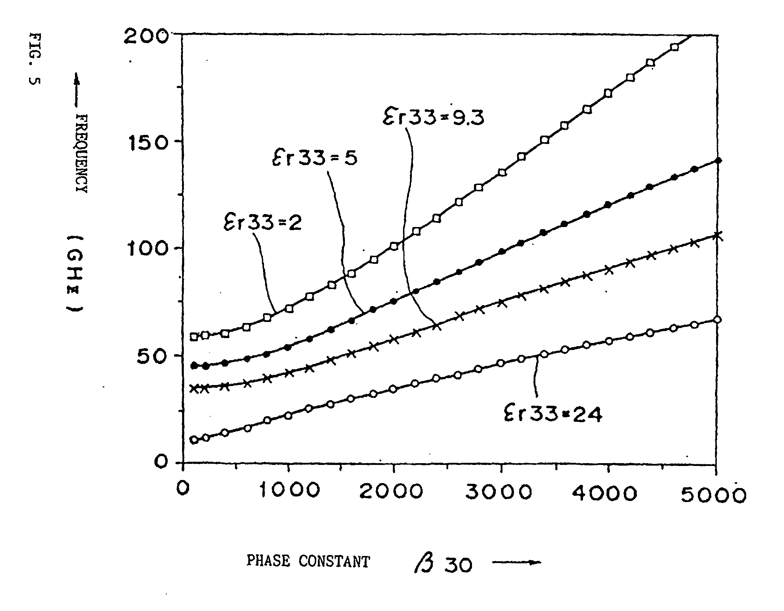

Fig. 5 is a diagram indicating the relation between the frequency and the phase constant β30 of the dielectric-loaded waveguide line LN30 when the dielectric constant $\varepsilon_r$33 of the substrate 33 was varied to have the values 2, 5, 9.3 and 24. The values indicated in Fig. 5 were calculated according to equations 5 and 6. The parameters of the structure of the waveguide line LN30 were set as follows:

(1) The thickness t33 of the substrate 33 = 0.33 mm; and
(2) The height h36 of the waveguide 36 = 2.25 mm

Fig. 5 reveals that a higher frequency causes a larger phase constant $\beta30$ and that a greater dielectric constant $\varepsilon_r33$ gives rise to a larger phase constant $\beta30$ under the condition of the same frequency.

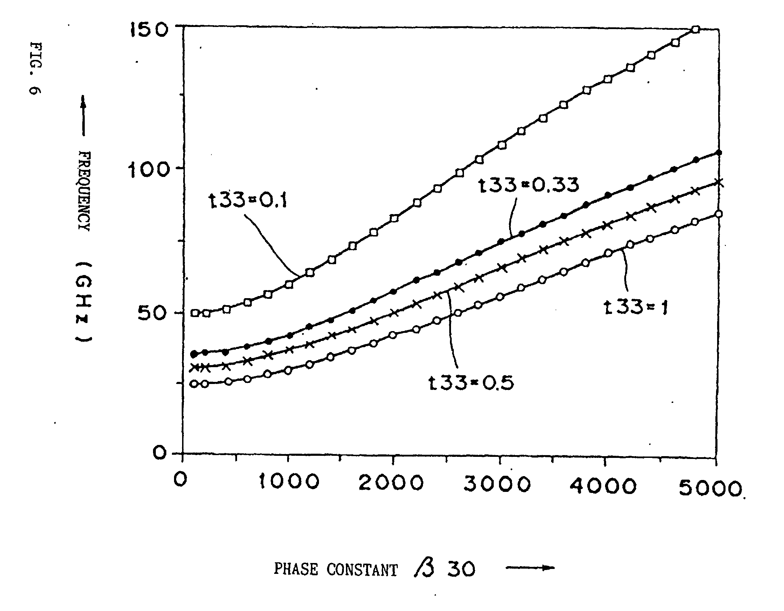

Fig. 6 is a diagram representing the relation between the frequency and the phase constant $\beta30$ of the waveguide line LN30 obtained when the thickness t of the substrate 33 was varied to have the values 0.1 mm, 0.33 mm, 0.5 mm and 1 mm. The values shown in Fig. 6 were calculated according to equations 5 and 6. The parameters of the structure of the waveguide line LN30 were set as follows:

(1) The dielectric constant $\varepsilon_r33$ of the substrate = 9.3; and
(2) The internal height h36 of the waveguide 36 = 2.25 mm

Fig. 6 demonstrates that a greater thickness t33 of the substrate 33 causes a greater phase constant $\beta30$ under the condition of the same frequency.

Next, the critical frequency fa at which the incidence angle $\Theta$ is equal to the critical angle $\Theta$c will be calculated with the use of the dielectric-loaded waveguide line LN30.

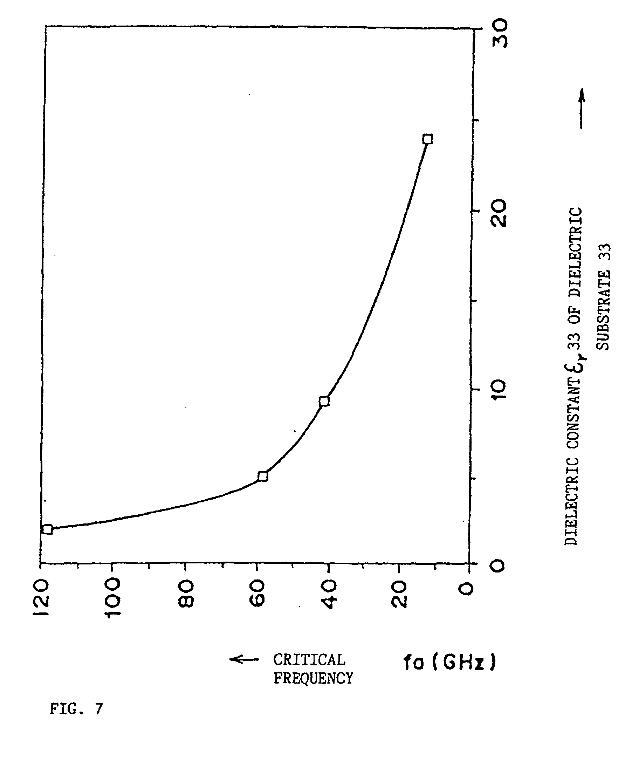

Fig. 7 is a diagram indicating the relation between the critical frequency fa at which the incidence angle $\Theta$ is equal to the critical angle $\Theta$c and the dielectric constant $\varepsilon_r33$ of the substrate 33. The parameters of the structure of the waveguide line LN30 were set as follows:

(1) The thickness t33 of the substrate 33 = 0.33 mm;
(2) The internal width W36 of the waveguide 36 = 2.0 mm; and
(3) The internal height h36 of the waveguide 36 = 2.25 mm.

As is seen from Fig. 7, a greater dielectric constant $\varepsilon_r33$ of the substrate 33 brings about a lower critical frequency fa. Namely, with a dielectric substrate 33 having a higher dielectric constant $\varepsilon_r33$, the minimum propagation frequency fb of a totally-reflecting high-frequency signal can be reduced to a lower level.

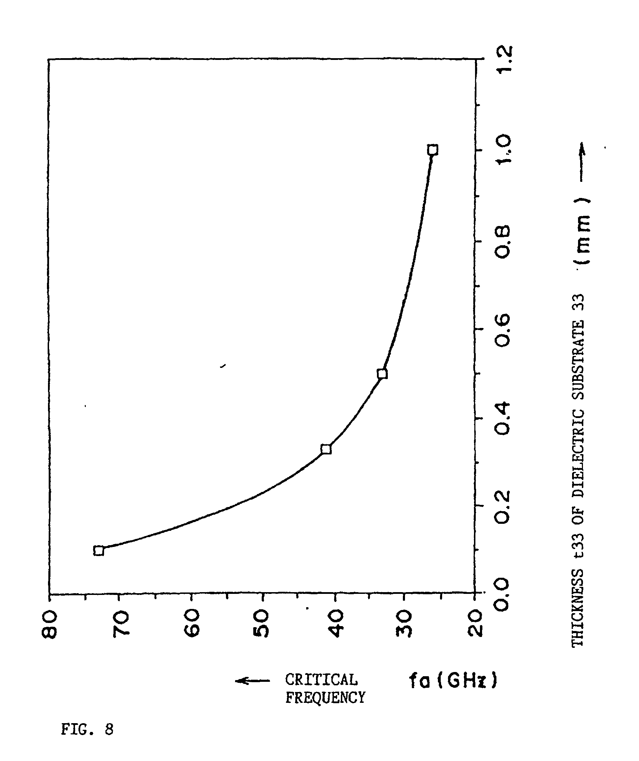

Fig. 8 is a diagram representing the relation between the critical frequency fa at which the incidence angle $\Theta$ is equal to the critical angle $\Theta$c and the thickness t33 of the substrate 33. The parameters of the structure of the waveguide line LN30 were set as follows:

(1) The dielectric constant $\varepsilon_r33$ of the substrate 33 = 9.3;
(2) The internal width W36 of the waveguide 36 = 2.0 mm; and
(3) The internal height h36 of the waveguide 36 = 2.25 mm.

Fig. 8 reveals that a greater thickness t33 of the substrate 33 causes a lower critical frequency fa at which the incidence angle $\Theta$ is equal to the critical angle $\Theta$c. That is, by increasing the thickness t33 of the substrate 33, the minimum propagation frequency fb of a totally reflecting high-frequency signal can be reduced to a lower level.

Based on the operation principle of the waveguide line LN30 explained above, the operation of the planar dielectric line LN20 (Fig. 12) of the second embodiment will now be described. The critical frequency fa of the dielectric line LN20 was calculated from the critical frequency fa of the dielectric line LN30 when the parameters of the line LN20 were set as follows:

(1) The thickness t23 of the substrate 23 = 0.33 mm;
(2) The width W20 of the substrate 23 = mm; and
(3) The widths W of the slots 24 and 25 = 2 mm.

The dielectric constant $\varepsilon_r23$ and the thickness t23 of the substrate 23 are respectively set equal to the dielectric constant $\varepsilon_r33$ and the thickness t33 of the substrate 33. Also, the widths W of the slots 24 and 25 of the substrate 23 are set equal to the internal width W of the waveguide 36. The spacing h41 between the upper and lower conductive plates 41a and 41b is set equivalent to the internal height h36 of the waveguide 36.

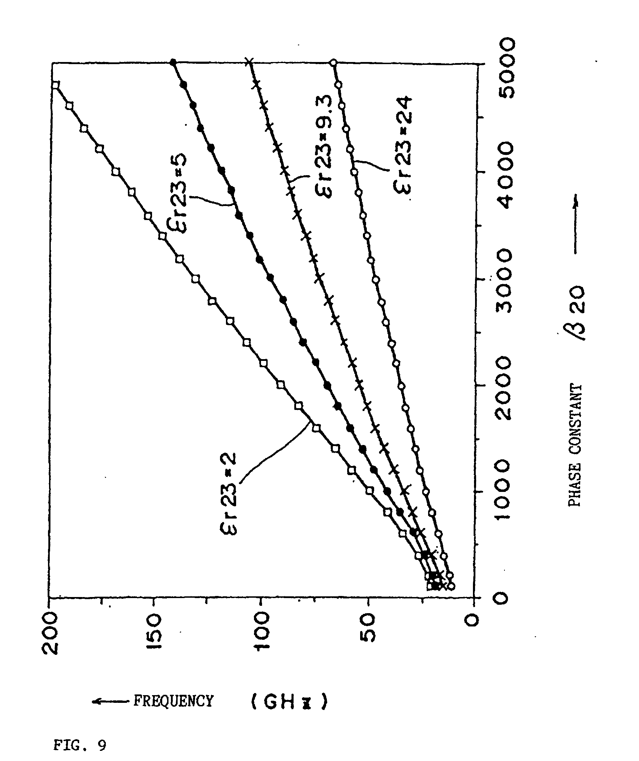

Fig. 9 is a diagram designating the relation between the frequency and the phase constant $\beta20$ of the dielectric line LN20 when the dielectric constant $\varepsilon_r23$ of the substrate 23 was set at the values 2, 5, 9.3 and 24. The values shown in Fig. 9 were calculated according to the finite-element method. Fig. 9 demonstrates that a higher frequency gives rise to a greater phase constant $\beta20$ and a greater dielectric constant $\varepsilon_r23$ brings about a greater phase constant $\beta20$ under the condition of the same frequency.

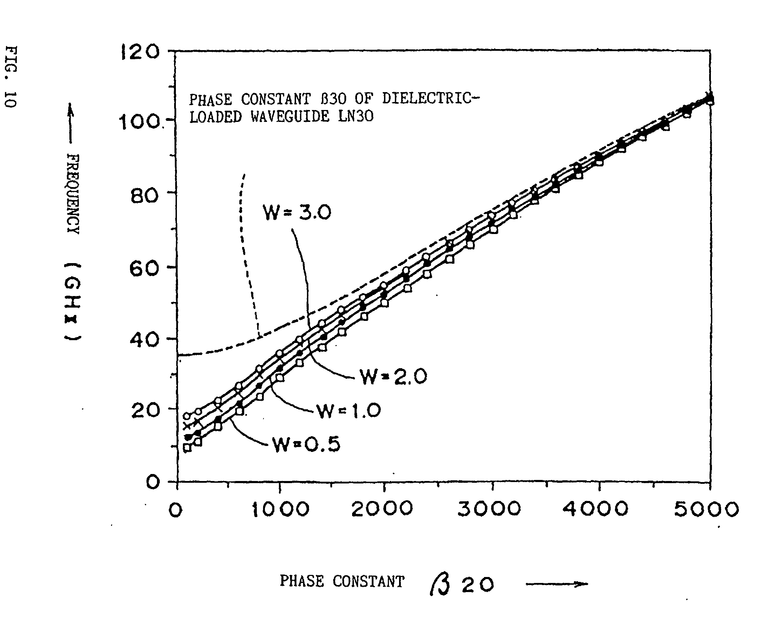

Fig. 10 is a diagram indicating the relation between the frequency and the phase constant $\beta20$ of the dielectric line LN20 when the widths W of the slots 24 and 25 of the substrate 23 were set at the values 0.5 mm, 1 mm, 2 mm and 3 mm. The values shown in Fig. 10 were calculated according to the finite-element method. The parameters of the structure of the dielectric line LN20 were set as follows:

(1) The dielectric constant $\varepsilon_r 23$ of the substrate 23 = 9.3;
(2) The width W20 of the substrate 23 = 8 mm; and
(3) The spacing h41 between the upper and lower conductive plates 41a and 41b = 2.25 mm.

Fig. 10 shows that a greater width W of the slots 24 and 25 causes a lower phase constant $\beta 20$ under the condition of the same frequency.

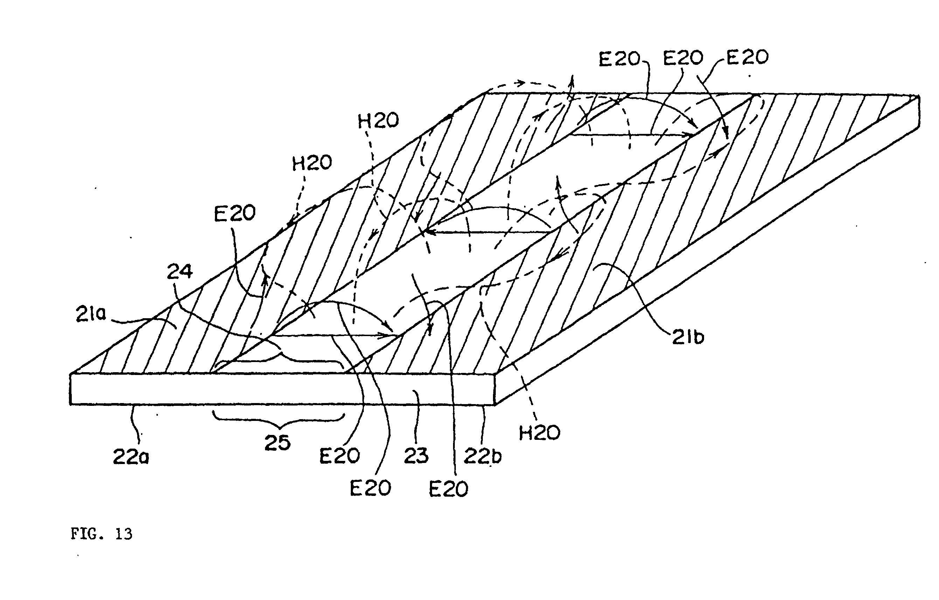

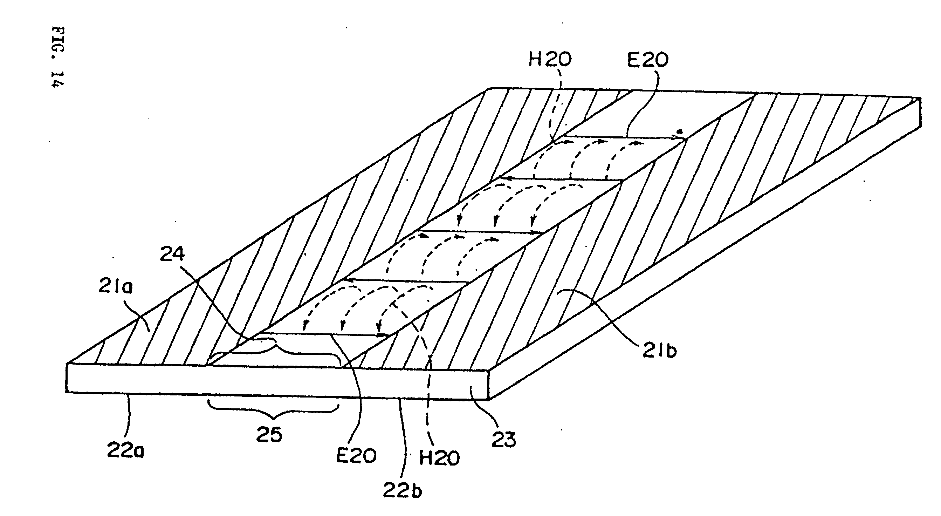

A further explanation will further be given of the electromagnetic-field distribution of the dielectric line LN20 (Fig. 12) according to the second embodiment. Fig. 13 illustrates the electromagnetic-field distribution in a perspective view of the dielectric substrate 23 as a comparative example when a high-frequency signal having a frequency lower than the critical frequency fa is input into the dielectric line LN20. In Fig. 13, the upper and lower conductive plates 41a and 41b are omitted and only the dielectric substrate 23 is shown. Also in the perspective view of Fig. 13, the top portions of the electrodes 21a and 21b are hatched for easy differentiation. As is clearly seen from Fig. 13, both the electric field E20 and the magnetic field H20 are distributed farther away from the vicinity of the substrate 23 than the electromagnetic-field distribution achieved at a frequency not lower than the critical frequency fa, as shown in Fig. 14.

Fig. 14 illustrates the electromagnetic distribution when a high-frequency signal having a frequency not lower than the critical frequency fa is input into the dielectric line LN20.

In Fig. 14, as well as Fig. 13, the upper and lower conductive plates 41a and 41b are omitted and only the substrate 23 is shown. Also, in the perspective view of Fig. 14, the top surfaces of the electrodes 21a and 21b are hatched for easy differentiation. Fig. 14 reveals that both the electric field E20 and the magnetic field H20 are concentrated only inside and in proximity of the propagation region 23c of the substrate 23d. More specifically, it is seen that a high-frequency signal having a frequency not lower than the critical frequency fa is totally reflected by top surface of the substrate 23 adjacent to the slot 24 and by the bottom surface of the substrate 23 in the vicinity of the slot 25.

Although only the operation of the dielectric line L20 has been discussed above, the dielectric line LN10 of the first embodiment is operated in a manner similar to the line LN20. As has been described above in detail, both the planar dielectric line LN10 of the first embodiment and the line LN20 of the second embodiment are operated in a manner similar to the dielectric-loaded waveguide line LN30 and used for transmitting a high-frequency signal having a frequency not lower than the critical frequency fa.

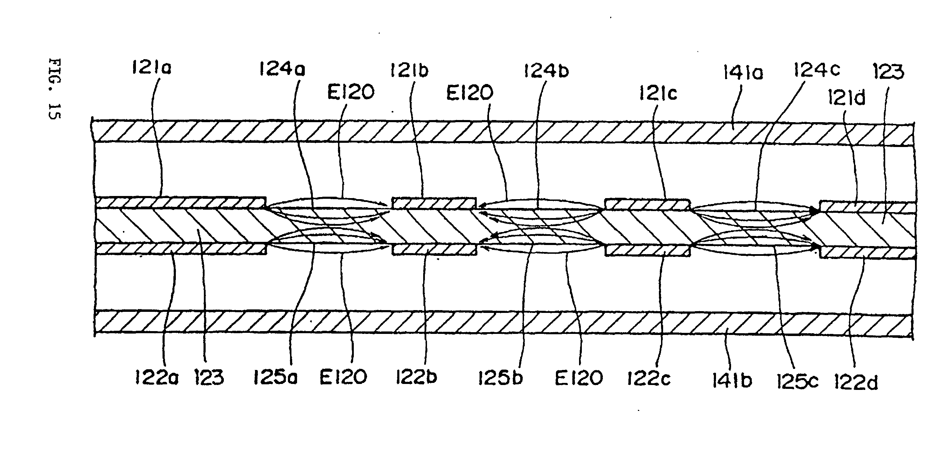

The present inventors observed the electric-field distribution by use of the model shown in Fig. 15 in order to examine the operation performed when two or more planar dielectric lines are disposed in proximity to each other. The construction of the model and results will be explained. In the model shown in Fig. 15, the electrodes 121a, 121b, 121c and 121d and the slots 124a, 124b and 124c are alternately formed on the top surface of the substrate along its width. More specifically, the slot 124a is disposed between the electrodes 121a and 121b; the slot 124b is located between the electrodes 121b and 121c; and the slot 124c is interposed between the electrodes 121c and 121d. The slots 124a, 124b and 124c are formed in parallel to the longitudinal direction of the substrate 23 and also have the same widths. The electrodes 121b and 121c also have the same widths.

Mounted on the bottom surface of the substrate 123 are electrodes 122a and 122b opposedly facing the electrodes 121a and 121b, respectively, across the substrate 123. Also, electrodes 122c and 122d are disposed opposedly facing the electrodes 121c and 121d, respectively, across the substrate 123. With this arrangement, slots 125a, 125b and 125c are located opposedly facing the slots 124a, 124b and 124c, respectively. The substrate 123 is disposed between the upper and lower conductive plates 141a and 141b in parallel to each other so that it can be placed in parallel thereto. The distance between the top surface of the substrate 123 and the upper conductive plate 141a can be equal to the distance between the bottom surface of the substrate 123 and the lower conductive plate 141b. Moreover, the upper and lower conductive plates 141a and 141b are spaced apart from each other in a manner similar to the second embodiment. The three planar dielectric lines in parallel to each other are thus constructed.

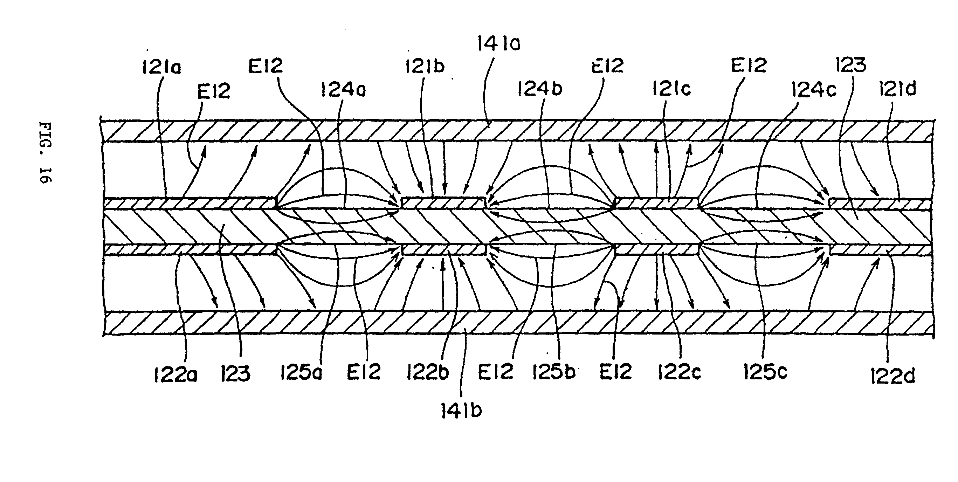

Fig. 15 illustrates an electric field E120 obtained when high-frequency signals having a frequency not lower than the critical frequency fa are transmitted in the three plane dielectric lines. Fig. 15 shows that the signals are transmitted in the longitudinal direction of the substrate 123 without interfering with each other. Fig. 16 indicates an electric field E12 resulting when high-frequency signals having a frequency lower than the critical frequency fa are transmitted in the three lines. Fig. 16 reveals that high-frequency signals suffer from electromagnetic-field coupling, i. e., electromagnetic-field interference.

As has been discussed above in detail, in the respective planar dielectric lines LN10 and LN20 of the first and second embodiments, a high-frequency signal having a frequency not lower than the critical frequency fa is totally reflected on the top surface of the substrate 23 adjacent to the slot 24 and on the bottom surface of the substrate 23 in the vicinity of the slot 25, whereby the signal can be propagated while concentrating its electromagnetic-field energy inside and in the proximity of the propagation region 23c of the substrate 23. To further develop these embodiments, it is possible to dispose a plurality of planar dielectric lines in parallel to each other along the width of the substrate 123, thus enabling the formation of highly-integrated circuits.

Third embodiment

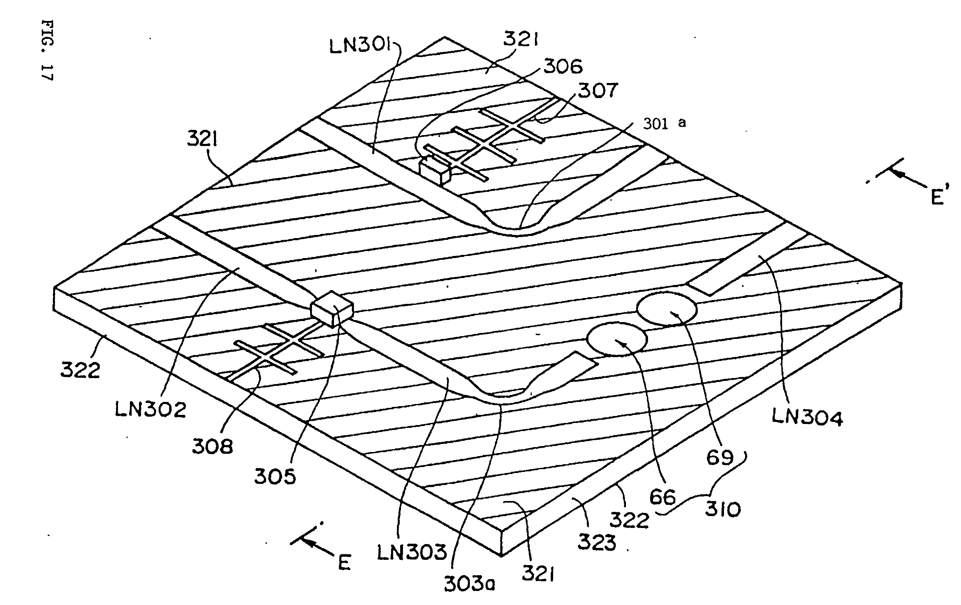

Fig. 17 is a perspective view of an integrated circuit produced by the application of the planar dielectric line according to the present invention. This integrated circuit is configured to have a generally-square dielectric substrate 323 provided with a plurality of dielectric lines. An electrode 321 with a predetermined shape is mounted on the top surface of the substrate 323, while an electrode 322 with a predetermined shape is formed on the bottom surface of the substrate 323, both the electrodes 321 and 322 opposedly facing each other. Accordingly, planar dielectric lines LN301, LN302, LN303 and LN304, a high pass filter 310, and biasing lines 307 and 308 are formed on the dielectric substrate 323. On the top surface of the substrate 323, a circuit part module 305 is connected between the dielectric lines LN302 and LN303, while a circuit part module 306 is connected between the dielectric line LN301 and the biasing line 307. The bent portions of the lines LN301 and LN303 are comprised of line portions 301a and 303a, respectively, formed by the narrowed slots. This makes it possible to bend the dielectric lines LN301 and LN303 without requiring a change from the propagation mode currently employed in the lines LN301 and LN303 to another mode.

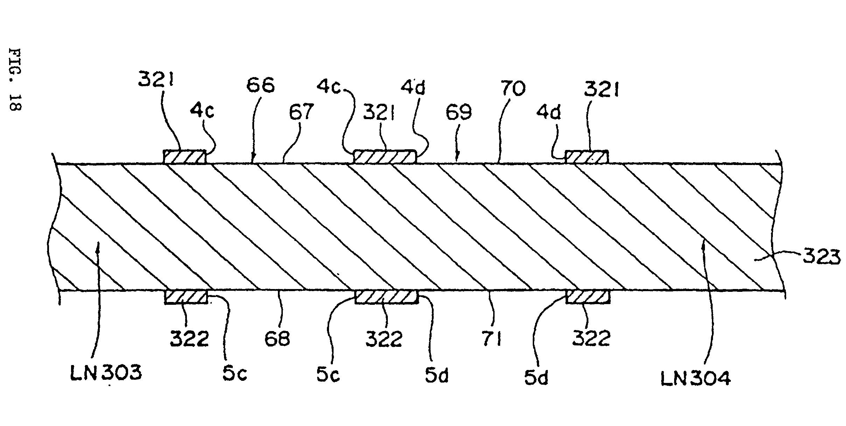

The high pass filter 310 will now be described. Fig. 18 is a sectional view along line E-E' of Fig. 17. As shown in Figs. 17 and 18, two circular openings 4c and 4d having the same diameter are formed on the top surface of the substrate 323. On the other hand, two circular openings 5c and 5d of the same size as the openings 4c and 4d are formed on the bottom surface of the substrate 323. The openings 4c and 4d are disposed between the dielectric lines LN303 and LN304 so that they can be located in parallel to each other across a predetermined spacing. Also, the openings 4d and 5d are coaxially formed to opposedly face each other. With this construction, two cylindrical resonator-forming regions 66 and 69 of the same shape are located between the dielectric lines LN303 and LN304. The resonator region 66, which is part of the substrate 323, is defined as a cylindrical region having the surface 67 of the opening 4c in the substrate 323 and the surface 68 of the opening 5c in the substrate 323. The resonator region 69, on the other hand, which is part of the substrate 323, is defined as a cylindrical region having the surface 70 of the opening 4d in the substrate 323 and the surface 71 of the opening 5d in the substrate 323.

The dielectric constant and the thickness of the substrate 323 and the diameters of the openings 4c, 4d, 5c and 5d are so determined as to generate a standing wave when the resonator regions 66 and 69 are excited by a high-frequency signal having the same frequency as a resonance frequency. Further, in the regions other than the resonator regions 66 and 69 and the propagation regions, i.e., dielectric lines LN301, LN302, LN303 and LN304, a planar-parallel waveguide is formed by electrodes 321 and 322. The dielectric constant and the thickness of the substrate 323 are also determined so that the cut-off frequency of the plane-parallel waveguide will be higher than a desired resonance frequency. With this arrangement, the resonator region 66 and adjacent free space, and the resonator region 69 and free space in the vicinity thereof, respectively constitute $TE_{010}$ mode-dielectric resonators. The regions 66 and 69 are separated from each other across a predetermined spacing so that the dielectric line LN303 and the $TE_{010}$ mode-dielectric resonator formed by the region 66 can be inductively coupled. The distance between the dielectric line LN304 and the region 69 is determined so that the dielectric line LN304 and the $TE_{010}$ mode-dielectric resonator formed by the region 69 can be inductively coupled.

In this manner, the high pass filter 310 is constructed by the cascade connection of the two $TE_{010}$ mode dielectric resonators between the dielectric lines LN303 and LN304. This causes a high-frequency signal having a predetermined frequency passing through the dielectric line LN303 being transmitted to the line LN304 through the two $TE_{010}$ mode-dielectric resonators.

Modified Embodiments

Examples of modifications of the present invention will now be explained.

The planar dielectric line LN10 of the first embodiment is comprised of the dielectric substrates 26 and 27, while the dielectric line LN20 of the second embodiment is formed with the use of the upper and lower conductive plates 41a and 41b. However, this is not exclusive, and the dielectric line may use only the dielectric substrate 23 provided with the slots 24 and 25. This modification also makes it possible to operate in a manner similar to the first and second embodiments and offers similar advantages, with a simpler construction.

Although the upper and lower conductive plates 41a and 41b are used for the dielectric line LN20 of the second embodiment, as described above, the present invention is not limited thereto.

Instead, a square waveguide defined by the upper and lower conductive plates 41a and 41b and lateral-surface conductors may be employed to form the line. With this modification, it is also possible to operate in a manner similar to the first and second embodiments and offer similar advantages.

In the dielectric line LN20 of the second embodiment, the distance between the upper conductive plate 41a and the top surface of the substrate 23 is determined to equal the distance between the lower conductive plate 41b and the bottom surface of the substrate 23. However, this is not exclusive, and the former distance may differ from the latter distance. The line obtained by the above modification is still operable in a manner similar to the first and second embodiments and can present the similar advantages.

Further, although the dielectric constant $\varepsilon_r 26$ of the dielectric substrate 26 is determined to be equal to the dielectric constant $\varepsilon_r 27$ of the substrate 27, they may differ from each other.

As will be clearly understood from the foregoing description, the present invention offers the following advantages.

In the planar dielectric line according to a first aspect of the present invention, a first slot having a predetermined width is formed on the first surface of the dielectric substrate, and a second slot is mounted on the second surface of the substrate, both the slots facing each other. This makes it possible to provide a small and inexpensive planar dielectric line that can enhance easier connection with electronic parts, such as ICs, and inhibit conductor losses to a lower level than microstrip lines, coplanar lines and slotted lines.

The planar dielectric line according to a second aspect of the present invention is constructed by adding first and second conductive plates to the planar dielectric line implemented by the first aspect of the present invention. It is thus possible to prevent leakage to the exterior of high-frequency signals propagating in the above-described dielectric line and also to preclude the entry of high-frequency signals from the exterior of the dielectric line.

In the planar dielectric line according to a third aspect of the present invention, the following features are added to the dielectric line implemented by the second aspect of the present invention. Namely, a dielectric is charged between the first surface of the dielectric substrate and the first conductive plate, and another dielectric is interposed between the second surface of the substrate and the second conductive plate, each dielectric having a smaller degree of permittivity than the dielectric substrate. The planar dielectric line can thus be made thinner.

An integrated circuit according to a fourth aspect of the present invention comprises a transmission line and a high-frequency device connected to the transmission line. The transmission line includes at least one of the planar dielectric lines implemented by the first to third aspects of the present invention. Accordingly, a highly-integrated circuit can be constructed.

## Claims

1. A planar dielectric transmission line comprising:

   a dielectric substrate (23) having first and second surfaces which opposedly face each other;

   a first slot (24) having a predetermined width (w) and being interposed between first and second electrodes (21a,21b), said first and second electrodes (21a,21b) being formed on the first surface of said dielectric substrate (23) and opposedly facing each other-across a predetermined spacing to define said first slot (24); and

   a second slot (25) having substantially the same width (w) as said first slot (24) and being interposed between third and fourth electrodes (22a,22b), said second slot (25) opposedly facing said first slot (24), said third and fourth electrodes (22a,22b) being formed on the second surface of said dielectric substrate (23) and opposedly facing each other across a predetermined spacing, to define said second slot (25),

   **characterized in that** the dielectric constant and the thickness of said dielectric substrate (23) are determined to form a propagation region (23c) in said dielectric substrate (23) between said first and second slots (24, 25), a first cut-off region (23a) in said dielectric substrate (23a) between said first (21a) and third (22a) electrodes, and a second cut-off region (23b) in said dielectric substrate (23) between said second (21b) and fourth (22b) electrodes, so that a plane electromagnetic wave having at least a predetermined frequency, which is higher than a cut-off frequency of said propagation region (23c), and propagating in said propagation region (23c) of said dielectric substrate (23) interposed between said first and second slots (24,25) is totally reflected by the first and second surfaces of said dielectric substrate (23) in said first and second slots (24,25), respectively, and so that said plane electromagnetic wave is attenuated in said first and second cut-off regions (23a, 23b) of said dielectric substrate (23).

2. A planar dielectric transmission line according to claim 1, further comprising:

   a first conductive plate (28) disposed away from the first surface of said dielectric substrate (23) across a predetermined distance; and

   a second conductive plate (29) disposed away from the second surface of said dielectric substrate (23) across a predetermined distance.

3. A planar dielectric transmission line according to claim 2, wherein a dielectric (26,27) is interposed between the first surface of said dielectric substrate (23) and said first conductive plate (28) and between the second surface of said dielectric substrate (23) and said second conductive plate (29), said dielectric (26,27) having a lower dielectric constant than that of said dielectric substrate (23).

4. A planar dielectric transmission line according to one of claims 1 to 3, wherein said cut-off frequency in said propagating region (23c) is substantially lower than a cut-off frequency in said first and second cut-off region (23a, 23b).

5. An integrated circuit comprising:

a planar dielectric transmission line; and

a high-frequency device connected to said transmission line,

said transmission line including:

a dielectric substrate (23) having first and second surfaces which opposedly face each other;

a first slot (24) having a predetermined width (w) and being interposed between first and second electrodes (21a,21b), said first and second electrodes (21a,21b) being formed on the first surface of said dielectric substrate (23) opposedly facing each other across a predetermined spacing to define said first slot (24); and

a second slot (25) having substantially the same width (w) as said first slot (24) and being interposed between third and fourth electrodes (22a,22b), said second slot (25) opposedly facing said first slot (24), said third and fourth electrodes (22a,22b) being formed on the second surface of said dielectric substrate (23) opposedly facing each other across a predetermined spacing to define said second slot (25),

wherein the dielectric constant and the thickness of said dielectric substrate (23) are determined to form a propagation region (23c) in said dielectric substrate (23) between said first and second slots (24, 25), a first cut-off region (23a) in said dielectric substrate (23a) between said first (21a) and third (22a) electrodes, and a second cut-off region (23b) in said dielectric substrate (23) between said second (21b) and fourth (22b) electrodes, so that a plane electromagnetic wave having at least a predetermined frequency, which is higher than a cut-off frequency of said propagation region (23c), and propagating in a propagation region (23c) of said dielectric substrate (23) interposed between said first and second slots (24,25) is totally reflected by the first and second surfaces of said dielectric substrate (23) in said first and second slots (24,25), respectively, and so that said plane electromagnetic wave is attenuated in said first and second cut-off regions (23a, 23b) of said dielectric substrate (23).

6. An integrated circuit according to claim 5, wherein said transmission line further includes:

a first conductive plate (28) disposed away from the first surface of said dielectric substrate (23) across a predetermined distance; and

a second conductive plate (29) disposed away from the second surface of said dielectric substrate (23) across a predetermined distance.

7. An integrated circuit according to claim 6, wherein a dielectric (26,27) is interposed between the first surface of said dielectric substrate (23) and said first conductive plate (28) and between the second surface of said dielectric substrate (23) and said second conductive plate (29), said dielectric (26,27) having a lower dielectric constant than that of said dielectric substrate (23).

8. An integrated circuit according to one of claims 5 to 7, wherein said cut-off frequency in said propagating region (23c) is substantially lower than a cut-off frequency in said first and second cut-off region (23a, 23b).

**Patentansprüche**

1. Eine planare dielektrische Übertragungsleitung, die folgende Merkmale umfaßt:

ein dielektrisches Substrat (23) mit einer ersten und einer zweiten Oberfläche, die einander gegenüberliegend zugewandt sind;

einen ersten Schlitz (24) mit einer vorbestimmten Breite (W), der zwischen einer ersten und einer zweiten Elektrode (21a, 21b) angeordnet ist, wobei die erste und die zweite Elektrode (21a, 21b) auf der ersten Oberfläche des dielektrischen Substrats (23) gebildet sind, und einander über einen vorbestimmten Abstand gegenüberliegend zugewandt sind, um den ersten Schlitz (24) zu definieren; und

einen zweiten Schlitz (25) mit im wesentlichen der gleichen Breite (W) wie der erste Schlitz (24), der zwischen einer dritten und einer vierten Elektrode (22a, 22b) angeordnet ist, wobei der zweite Schlitz (25) dem ersten Schlitz (24) gegenüberliegend zugewandt ist, wobei die dritte und die vierte Elektrode (22a, 22b) auf der zweiten Oberfläche des dielektrischen Substrats (23) gebildet sind, und einander über einen vorbestimmten Abstand gegenüberliegend zugewandt sind, um den zweiten Schlitz (25) zu definieren,

**dadurch gekennzeichnet, daß**
die dielektrische Konstante und die Dicke des dielektrischen Substrats (23) bestimmt sind, um eine Ausbreitungsregion (23c) in dem dielektrischen Substrat (23) zwischen dem ersten und dem zweiten Schlitz (24, 25), eine erste Grenzregion (23a) in dem dielektrischen Substrat (23) zwischen der ersten (21a) und der dritten (22a) Elektrode, und eine zweite Grenzregion (23b) in dem dielektrischen Substrat (23) zwischen der zweiten (21b) und der vierten (22b) Elektrode zu bilden, so daß eine ebene elektromagnetische Welle, die zumindest eine vorbestimmte Frequenz aufweist, die höher ist als eine Grenzfrequenz der Ausbreitungsregion (23c) und sich in der Ausbreitungsregion (23c) des dielektrischen Substrats (23) ausbreitet, die zwischen dem ersten und dem zweiten Schlitz (24, 25) angeordnet ist, vollständig durch die erste und die zweite Oberfläche des dielektrischen Substrats (23) in dem ersten beziehungsweise dem zweiten Schlitz (24, 25) reflektiert wird, und so daß die ebene elektromagnetische Welle in der ersten und der zweiten Grenzregion (23a, 23b) des dielektrischen Substrats (23) gedämpft wird.

2. Eine planare dielektrische Übertragungsleitung gemäß Anspruch 1, die ferner folgende Merkmale umfaßt:

eine erste leitfähige Platte (28), die entfernt von der ersten Oberfläche des dielektrischen Substrats (23) über einen vorbestimmten Abstand angeordnet ist; und

eine zweite leitfähige Platte (29), die entfernt von der zweiten Oberfläche des dielektrischen Substrats (23) über einen vorbestimmten Abstand angeordnet ist.

3. Eine planare dielektrische Übertragungsleitung gemäß Anspruch 2, bei der ein Dielektrikum (26, 27) zwischen der ersten Oberfläche des dielektrischen Substrats (23) und der ersten leitfähigen Platte (28) und zwischen der zweiten Oberfläche des dielektrischen Substrats (23) und der zweiten leitfähigen Platte (29) angeordnet ist, wobei das Dielektrikum (26, 27) eine geringere dielektrische Konstante aufweist als diejenige des dielektrischen Substrats (23).

4. Eine planare dielektrische Übertragungsleitung gemäß einem der Ansprüche 1 bis 3, bei der die Grenzfrequenz in der Ausbreitungsregion (23c) wesentlich niedriger ist als eine Grenzfrequenz in der ersten und der zweiten Grenzregion (23a, 23b).

5. Eine integrierte Schaltung, die folgende Merkmale umfaßt:

eine planare dielektrische Übertragungsleitung; und

ein Hochfrequenzgerät, das mit der Übertragungsleitung verbunden ist,

wobei die Übertragungsleitung folgende Merkmale umfaßt:

ein dielektrisches Substrat (23) mit einer ersten und einer zweiten Oberfläche, die einander gegenüberliegend zugewandt sind;

einen ersten Schlitz (24) mit einer vorbestimmten Breite (W), der zwischen einer ersten und einer zweiten Elektrode (21a, 21b) angeordnet ist, wobei die erste und die zweite Elektrode (21a, 21b) auf der ersten Oberfläche des dielektrischen Substrats (23) gebildet sind, und einander über einen vorbestimmten Abstand gegenüberliegend zugewandt sind, um den ersten Schlitz (24) zu definieren; und

einen zweiten Schlitz (25) mit im wesentlichen der gleichen Breite (W) wie der erste Schlitz (24), der zwischen einer dritten und einer vierten Elektrode (22a, 22b) angeordnet ist, wobei der zweite Schlitz (25) dem ersten Schlitz (24) gegenüberliegend zugewandt ist, wobei die dritte und die vierte Elektrode (22a, 22b) auf der zweiten Oberfläche des dielektrischen Substrats (23) gebildet sind, und einander über einen vorbestimmten Abstand gegenüberliegend zugewandt sind, um den zweiten Schlitz (25) zu definieren,

wobei die dielektrische Konstante und die Dicke des dielektrischen Substrats (23) bestimmt sind, um eine Ausbreitungsregion (23c) in dem dielektrischen Substrat (23) zwischen dem ersten und dem zweiten Schlitz (24, 25), eine erste Grenzregion (23a) in dem dielektrischen Substrat (23) zwischen der ersten (21a) und der dritten (22a) Elektrode, und eine zweite Grenzregion (23b) in dem dielektrischen Substrat (23) zwischen der zweiten (21b) und der vierten (22b) Elektrode zu bilden, so daß eine ebene elektromagnetische Welle, die zumindest eine vorbestimmte Frequenz aufweist, die höher ist als eine Grenzfrequenz der Ausbreitungsregion (23c) und sich in der Ausbreitungsregion (23c) des dielektrischen Substrats (23) ausbreitet, die zwischen dem ersten und dem zweiten Schlitz (24, 25) angeordnet ist, vollständig durch die erste und die zweite Oberfläche des dielektrischen Substrats (23) in dem ersten beziehungsweise dem zweiten Schlitz (24, 25) reflektiert wird, und so daß die ebene elektromagnetische Welle in der ersten und der zweiten Grenzregion (23a, 23b) des dielektrischen Substrats (23) gedämpft wird.

6. Eine integrierte Schaltung gemäß Anspruch 5, die ferner folgende Merkmale umfaßt:

eine erste leitfähige Platte (28), die entfernt von der ersten Oberfläche des dielektrischen Substrats (23) über einen vorbestimmten Abstand angeordnet ist; und
eine zweite leitfähige Platte (29), die entfernt von der zweiten Oberfläche des dielektrischen Substrats (23) über einen vorbestimmten Abstand angeordnet ist.

7. Eine integrierte Schaltung gemäß Anspruch 6, bei der ein Dielektrikum (26, 27) zwischen der ersten Oberfläche des dielektrischen Substrats (23) und der ersten leitfähigen Platte (28) und zwischen der zweiten Oberfläche des dielektrischen Substrats (23) und der zweiten leitfähigen Platte (29) angeordnet ist, wobei das Dielektrikum (26, 27) eine geringere dielektrische Konstante aufweist als diejenige des dielektrischen Substrats (23).

8. Eine integrierte Schaltung gemäß einem der Ansprüche 5 bis 7, bei der die Grenzfrequenz in der Ausbreitungsregion (23c) wesentlich niedriger ist als eine Grenzfrequenz in der ersten und der zweiten Grenzregion (23a, 23b).

**Revendications**

1. Ligne diélectrique triplaque de transmission comprenant :

un substrat diélectrique (23) ayant des première et deuxième surfaces qui se font face l'une à l'autre en étant opposées;
une première fente (24) qui a une largeur prédéterminée (w) et qui est interposée entre des première et deuxième électrodes (21a, 21b), lesdites première et deuxième électrodes (21a, 21b) étant formées sur la première surface dudit substrat diélectrique (23) et se faisant face l'une à l'autre en étant opposées à travers un espacement prédéterminé pour définir ladite première fente (24); et
une deuxième fente (25) qui a sensiblement la même largeur (w) que la première fente (24) et qui est interposée entre des troisième et quatrième électrodes (22a, 22b), ladite deuxième fente (25) faisant face en y étant opposée à la première fente (24), lesdites troisième et quatrième électrodes (22a, 22b) étant formées sur la deuxième surface dudit substrat diélectrique (23) et se faisant face en étant opposées l'une à l'autre à travers un espacement prédéterminé, pour définir ladite deuxième fente (25),

**caractérisé en ce que** la constante diélectrique et l'épaisseur dudit substrat diélectrique (23) sont déterminées de façon à former une zone de propagation (23c) dans ledit substrat diélectrique (23) entre Lesdites première et deuxième fentes (24, 25), une première zone de coupure (23a) dans ledit substrat diélectrique (23a) entre lesdites première (21 a) et troisième (22a) électrodes et une deuxième zone de coupure (23b) dans ledit substrat diélectrique (23) entre lesdites deuxième (21b) et quatrième (22b) électrodes, de telle façon qu'une onde électromagnétique plane ayant au moins une fréquence prédéterminée qui est plus élevée qu'une fréquence de coupure de ladite zone de propagation (23c) et se propageant dans ladite zone de propagation (23c) dudit substrat diélectrique (23) interposée entre lesdites première et deuxième fentes (24, 25) soit totalement réfléchie par les première et deuxième surfaces dudit substrat diélectrique (23) dans lesdites première et deuxième fentes (24, 25), respectivement, et de telle façon que ladite onde électromagnétique plane soit atténuée dans lesdites première et deuxième zones de coupure (23a, 23b) dudit substrat diélectrique (23).

2. Ligne diélectrique triplaque de transmission selon la revendication 1, comprenant de plus:

une première plaque conductrice (28) disposée espacée de la première surface dudit substrat diélectrique (23) d'une distance prédéterminée; et
une deuxième plaque conductrice (29) disposée espacée de la deuxième surface dudit substrat diélectrique (23) d'une distance prédéterminée.

3. Ligne diélectrique triplaque de transmission selon la revendication 2, dans laquelle un diélectrique (26, 27) est interposé entre la première surface dudit substrat diélectrique (23) et ladite première plaque conductrice (28) et entre la deuxième surface dudit substrat diélectrique (23) et ladite deuxième plaque conductrice (29), ledit diélectrique (26, 27) ayant une constante diélectrique inférieure à celle dudit substrat diélectrique (23).

4. Ligne diélectrique triplaque de transmission selon l'une quelconque des revendications 1 à 3, dans laquelle ladite fréquence de coupure dans ladite zone de propagation (23c) est sensiblement inférieure à une fréquence de coupure dans lesdites première et deuxième zones de coupure (23a, 23b).

5. Circuit intégré comprenant :

une ligne diélectrique triplaque de transmission; et
un dispositif de haute fréquence connecté à ladite ligne de transmission, ladite ligne de transmission comprenant :

un substrat diélectrique (23) ayant des première et deuxième surfaces qui se font face l'une à l'autre en étant opposées;
une première fente (24) qui a une largeur prédéterminée (w) et qui est interposée entre des première et deuxième électrodes (21a, 21b), lesdites première et deuxième électrodes (21a, 21b) étant formées sur la première surface dudit substrat diélectrique (23) de façon à se faire face l'une à l'autre en étant opposées à travers un espacement prédéterminé pour définir ladite première fente (24); et
une deuxième fente (25) ayant sensiblement la même largeur (w) que ladite première fente (24) et qui est interposée entre des troisième et quatrième électrodes (22a, 22b), ladite deuxième fente (25) faisant face en y étant opposée à ladite première fente, lesdites troisième et quatrième électrodes (22a, 22b) étant formées sur la deuxième surface dudit substrat diélectrique (23) se faisant face l'une à l'autre en étant opposées à travers un espacement prédéterminé pour définir ladite deuxième fente (25),

dans lequel la constante diélectrique et l'épaisseur dudit substrat diélectrique (23) sont déterminées de façon à former une zone de propagation (23c) dans ledit substrat diélectrique (23) entre lesdites première et deuxième fentes (24, 25), une première zone de coupure (23a) dans ledit substrat diélectrique (23a) entre lesdites première (21a) et troisième (22a) électrodes et une deuxième zone de coupure (23b) dans ledit substrat diélectrique (23) entre lesdites deuxième (21b) et quatrième (22b) électrodes, de telle façon qu'une onde électromagnétique plane ayant au moins une fréquence prédéterminée qui est supérieure à une fréquence de coupure de ladite zone de propagation (23c) et se propageant dans une zone de propagation (23c) dudit substrat diélectrique (23) interposée entre lesdites première et deuxième fentes (24, 25) soit totalement réfléchie par les première et deuxième surfaces dudit substrat diélectrique (23) dans lesdites première et deuxième fentes (24, 25), respectivement, et de telle façon que ladite onde électromagnétique plane soit atténuée dans lesdites première et deuxième zones de coupure (23a, 23b) dudit substrat diélectrique (23).

6. Circuit intégré selon la revendication 5, dans lequel ladite ligne de transmission comprend de plus :

une première plaque conductrice (28) disposée espacée de la première surface dudit substrat diélectrique (23) d'une distance prédéterminée; et
une deuxième plaque conductrice (29) disposée espacée de la deuxième surface dudit substrat diélectrique (23) d'une distance prédéterminée.

**7.** Circuit intégré selon la revendication 6, dans lequel un diélectrique (26, 27) est interposé entre la première surface dudit substrat diélectrique (23) et ladite première plaque conductrice (28) et entre la deuxième surface dudit substrat diélectrique (23) et ladite deuxième plaque conductrice (29), ledit diélectrique (26, 27) ayant une constante diélectrique inférieure à celle dudit substrat diélectrique (23).

**8.** Circuit intégré selon l'une quelconque des revendications 5 à 7, dans laquelle ladite fréquence de coupure dans ladite zone de propagation (23c) est sensiblement inférieure à une fréquence de coupure dans lesdites première et deuxième zones de coupure (23a, 23b).

FIG. 1

LN 10

CUT-OFF REGION ⟷ PROPAGATION REGION ⟷ CUT-OFF REGION

W20

.W

21a  21b  28

26a  t26  24  26b

23a  t23  23c  23b

27a  t27  25  27b

22a  22b  29

A  A'

27  26  x  z  y  23

EP 0 735 604 B1

FIG. 2

EP 0 735 604 B1

LN30

FIG. 3

H30    36

E30

33

H30

FIG. 4A

36

H30    E30    E30    H30    H30

33

E30    E30

E30

FIG. 4B

FIG. 5

FIG. 6

FREQUENCY (GHz)

150

100

t33=0.1

t33=0.33

50

t33=0.5

t33=1

0

0    1000   2000   3000   4000   5000

PHASE CONSTANT β 30 →

EP 0 735 604 B1

23

FIG. 7

EP 0 735 604 B1

CRITICAL FREQUENCY fa (GHz)

DIELECTRIC CONSTANT $\varepsilon_r$ 33 OF DIELECTRIC SUBSTRATE 33

FIG. 8

FIG. 9

FIG. 10

PHASE CONSTANT β30 OF DIELECTRIC-
LOADED WAVEGUIDE LN30

W = 3.0

W = 2.0

W = 1.0

W = 0.5

FREQUENCY (GHz)

PHASE CONSTANT $\beta$ 20

EP 0 735 604 B1

FIG. 11A

FIG. 11B

FIG. 12

FIG. 13

FIG. 14

FIG. 15

FIG. 16

FIG. 17

FIG. 18

FIG. 19

EP 0 735 604 B1